# EUROPEAN PATENT SPECIFICATION

(11) **EP 0 287 111 B1**
(45) Date of publication and mention of the grant of the patent: **21.07.1993**
(21) Application number: 88106043.8
(22) Date of filing: 15.04.1988
(51) Int. Cl.: H05K 3/40, H05K 3/34, H01R 9/09, H01L 21/98

(54) **Method for manufacturing an electronic part**
Verfahren zur Herstellung einer elektronischen Vorrichtung
Procédé de fabrication d'un dispositif électronique

(30) Priority: 15.04.1987 JP 92508/87
(43) Date of publication of application: 19.10.1988
(73) Proprietor: MATSUSHITA ELECTRIC INDUSTRIAL CO., LTD., Kadoma-shi, Osaka-fu, 571 (JP)
(72) Inventor: Takemoto, Yoshiro, Hirakata-shi Osaka-fu (JP); Asano, Kenji, Neyagawa-shi Osaka-fu (JP)
(74) Representative: Eisenführ, Speiser & Partner

(56) References cited:
- US-A- 4 177 554
- RCA TECHNICAL NOTES, no. 1317, October 1982, pages 1-3, RCA, Princeton, NJ, US; J.P. HEENAN et al.: "Method for attaching edge terminals"
- PATENT ABSTRACTS OF JAPAN, vol. 7, no. 36 (E-158)[1181], 15th February 1983 & JP-A-57 190 339 (PIONEER K.K.) 22-11-1982

## Description

### BACKGROUND OF THE INVENTION

### 1. Field of the Invention

The present invention generally relates to a method for manufacturing an electronic part such as a hybrid integrated circuit.

### 2. Description of the Prior Art

Recent increased need for utilization of electronic parts has consequently given much importance to the method for manufacturing the electronic parts.

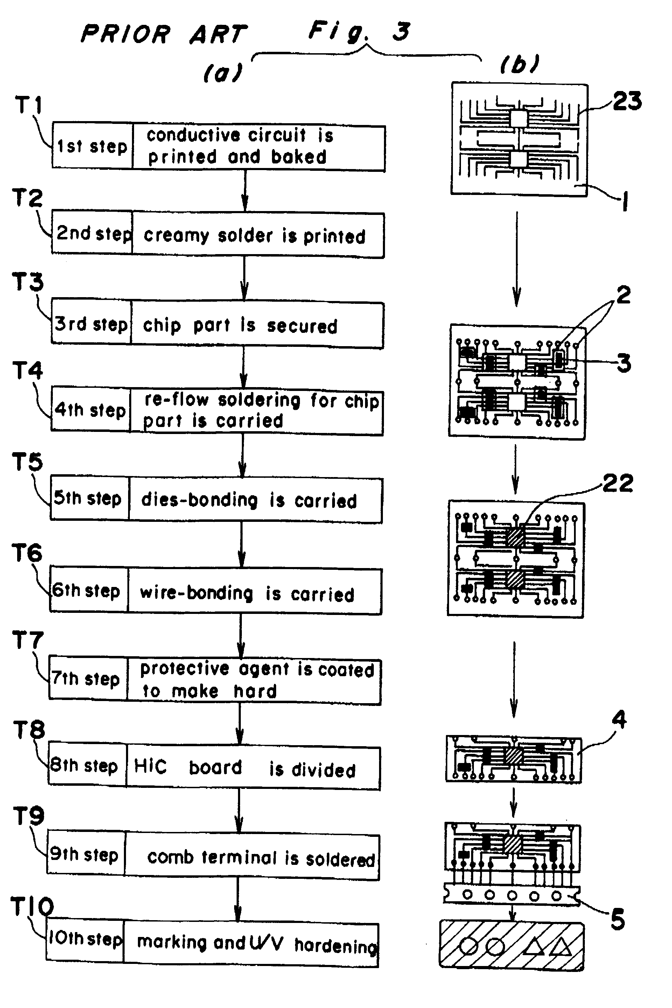

One example of a conventional method for manufacturing electronic parts will be described with reference to a flow-chart of Fig. 3. The flow-chart of Fig. 3 shows the sequence of operations in the conventional manufacturing method of electronic parts. A hybrid integrated circuit board 1 (hereinafter referred to as an HiC board) which is a ceramic board in the present example is finished with printing and baking. A creamy solder 2 is used onto the HiC board 1 for securing a chip part 3 and a comb terminal 5 wherein a plurality of terminals are mounted in parallel arrangement on a strip member to form a chain of terminals like as a comb in a long length of the strip member. The HiC board 1 is divided into units of parts 4. The comb terminal 5 having its own length independently from each other per every part 4 is connected to the HiC board 1 by the creamy solder 2.

The conventional manufacturing method referred to above includes ten steps of operations as follows.

In the first step T1, a circuit pattern is printed on the HiC board 1 by a paste-like conductor, and then the HiC board 1 and the conductor are heated to securely bake a conductive circuit 23 onto the HiC board 1.

In the second step T2, the creamy solder 2 is printed on the portions of the HiC board 1 where the chip part 3 is to be mounted and the comb terminal 5 is to be connected.

In the third step T3, the chip part 3 is mounted onto the printed creamy solder 2.

In the fourth step T4, the HiC board 1, the creamy solder 2 and the mounted chip part 3 are heated, and accordingly, the creamy solder 2 is melted, so that the chip part 3 and the HiC board 1 are mechanically connected to each other, that is, re-flow soldering is carried out.

In the fifth step T5, a semiconductive element 22 is fixed onto the HiC board 1 by a bonding agent (not shown), that is, dies-bonding is carried out.

In the sixth step T6, the semiconductive element 22 which has been securely bonded onto the HiC board 1 in the fifth step is mechanically connected to the conductive circuit 23 on the HiC board 1 by a fine wire (not shown) made of gold or aluminum, namely, wire-bonding is carried out.

In the seventh step T7, a protective agent is coated for protecting the semiconductive element 22 and the fine wire connecting the semiconductive element 22 and the conductive circuit 23, and is then thermally hardened.

In the eighth step T8, the HiC board 1 is divided by a predetermined size.

In the ninth step T9, the comb terminal 5, which is provided for electrical connection with an external circuit, is subjected to re-flow soldering through melting of the creamy solder 2 in a re-flow furnace.

Finally, in the tenth step T10, a number is marked on a predetermined position of the HiC board 1 by an ultraviolet hardening ink (not shown), and the ink is hardened through irradiation of ultraviolet rays (UV hardening), thereby to completed the electronic part.

In the above-described flow of operations, however, at least two re-flow furnaces are required for securing the chip part onto the HiC board and for connecting the comb terminal to the HiC board. Moreover, the above-described prior art necessitates transfer and mounting devices to be provided respectively for the HiC board and for the comb terminal. As a result, the manufacturing apparatus is inevitably bulky and expensive. Furthermore, the HiC board is subjected to many heating and cooling operations in the two re-flow furnaces, resulting in distortion of the HiC board and consequently in such disadvantages that a good product accuracy is difficult to be achieved, and the yield is deteriorated.

### SUMMARY OF THE INVENTION

Accordingly, an essential object of the present invention is to provide an improved method for manufacturing electronic parts, with elimination of the above-described disadvantages inherent in the conventional manufacturing methods.

Another object of the present invention is to provide an improved method for manufacturing electronic parts of the type referred to above, in which an electronic chip part mounted on the board is mechanically connected to the wiring pattern on the board concurrently when the comb terminal is mechanically connected to the wiring pattern on the board, during the soldering process.

According to the manufacturing method of the present invention, a pair of elongated comb terminals, not a comb terminal independently separated from each other, are placed parallel to each other and transferred in a longitudinal direction so as to mechanically fix a board of substrate to the pair of the comb terminals. Accordingly, the board is transferred while the comb terminals are transferred. During the transfer of the board, necessary operations for mounting chip parts onto the board and for soldering are performed. Thereafter, the comb terminals are cut off to obtain electronic parts.

Accordingly, the comb terminal and the chip part can be soldered to the printed circuit board at one time, resultating in reduction of the number of necessary soldering machines, and at the same time, reduction of possibilities of thermal distortion of the printed circuit board. Further, according to the present invention, the respective transfer means and mounting tools for the printed circuit board and for the comb terminal can be commonly used or disused.

### BRIEF DESCRIPTION OF THE DRAWINGS

These and other objects and features of the present invention will become clear from the following description taken in conjunction with the preferred embodiments thereof with reference to the accompanying drawings, in which:
Fig. 1 is a perspective view of a part of an apparatus for embodying the manufacturing method of electronic parts according to one preferred embodiment of the present invention;
Fig. 2 is a flow-chart showing the manufacturing process in the manufacturing method of the present invention; and
Fig. 3 is a flow-chart showing the manufacturing process according to a conventional manufacturing method of electronic parts.

### DETAILED DESCRIPTION OF THE INVENTION

Before the description of the present invention proceeds, it is to be noted that like parts are designated by like reference numerals throughout the accompanying drawings.

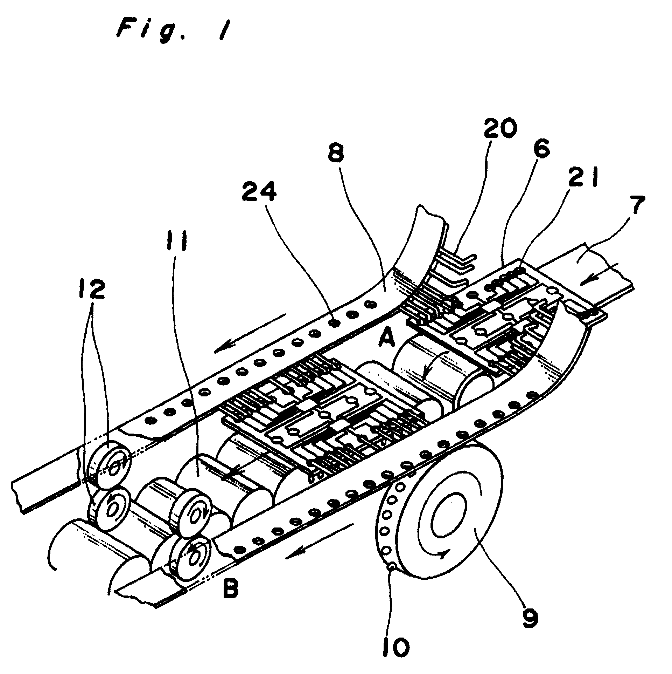

Referring to Fig. 1 for explaining one preferred embodiment of the present invention, a ceramic board of base plate 6 which has a conductive circuit printed and baked thereon as a board of hybrid integrated circuit is arranged to be transferred by a belt conveyor 7 from a previous step. Terminals each connected to every one ceramic board 6 are serially connected to form an elongated comb terminal 8, wherein a plurality of terminals are mounted in parallel arrangement on the board to form a chain of terminals like as a comb along a longitudinal direction of the board. A driving roller 9 for driving the comb terminal 8 has pins 10 provided on the outer periphery thereof so as to drive the comb terminal 8 through engagement of the pins 10 with transfer apertures 24 formed in the comb terminal 8. There is further provided a roller 11 which supports the ceramic board 6 from below since the ceramic board 6 is drawn by the comb terminal 8 when only the comb terminal 8 is driven by the driving roller 9 and the pins 10 after both the comb terminal 8 and the ceramic board 6 are mechanically connected at the position A, thereby to smoothly transfer the ceramic board 6. A pair of caulking rollers 12 transfer, and at the same time, grasp the portions from up and down where the ceramic board 6 and the comb terminal 8 are mechanically connected, by mutual rotation, so that the foot portions of the comb terminal 8 are bent to be temporarily secured to the ceramic board 6.

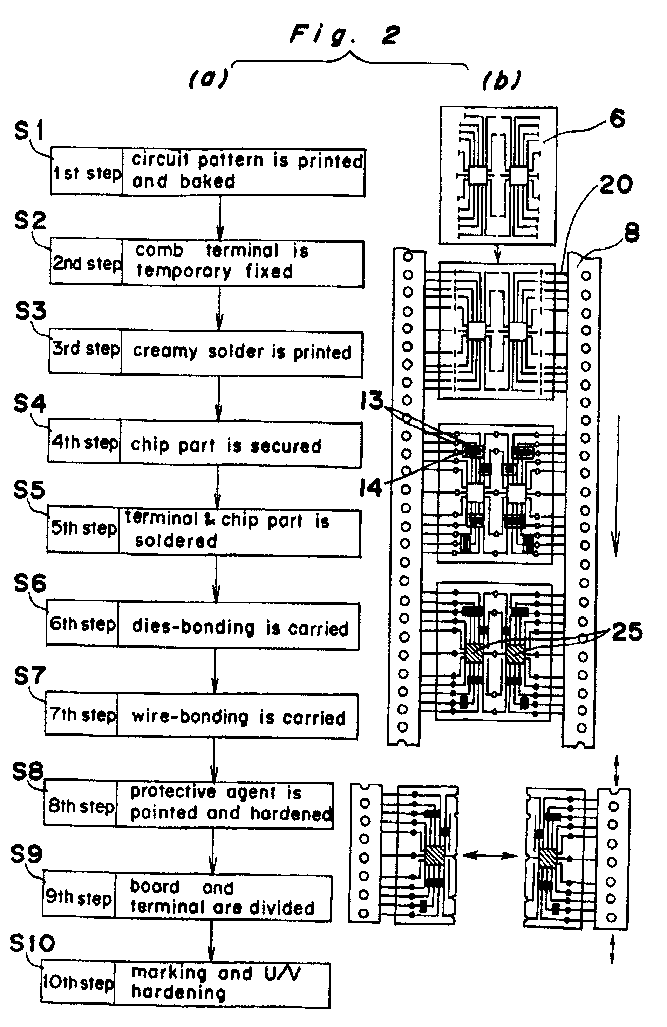

Referring to the flow-chart of Fig. 2, each step in the manufacturing process according to the manufacturing method of the present invention will be described.

The manufacturing process is comprised of ten steps. In other words, in the first step S1, a circuit pattern is printed by a pasty conductive material on the ceramic board 6, and the conductive circuit is baked onto the ceramic board 6 by heating the board and the conductive material. In the second step S2, a pair of elongated comb terminals 8 is mechanically connected to the ceramic board 6 for temporary fixing. In the third step S3, a creamy solder 13 is printed on predetermined terminals of the ceramic board 6 for securing a chip part 14 and the comb terminals 8. In the fourth step S4, the chip part 14 is mounted on the printed creamy solder 13. In the fifth step S5, the ceramic board 6 and the comb terminals 8, and the ceramic board 6 and the chip part 14 are respectively mechanically connected to each other by re-flow soldering through heating and melting of the creamy solder 13 in the re-flow furnace. In the sixth step S6, a semiconductive element 25 is fixedly bonded to the ceramic board 6 at a predetermined position by a bonding agent (not shown), namely, dies-bonding is carried out. In the seventh step S7, the semiconductive element 25 is electrically connected to the conductive circuit provided on the ceramic board 6 by a fine wire made of gold or aluminum, that is, wire-bonding is performed. In the eighth step S8, a protective agent (not shown) is coated over the semiconductive element 25 and also the fine wire connecting the element 25 with the ceramic board 6, and at the same time, the protective agent is heat cured. In the ninth step S9, the ceramic board 6 and the comb terminals 8 are cut off into a given size. In the tenth step S10, the ceramic board 6 is marked with a number, etc. on a predetermined position thereof by an ultraviolet hardening ink which is in turn irradiated by ultraviolet rays to be hardened (UV hardening), thereby to complete the product.

The manufacturing method of electronic parts comprised of the above-described steps of process will be described further with reference to Figs. 1 and 2.

First, as shown in Fig. 1, the ceramic board 6 which has a conductive circuit printed and baked thereon in the previous step is transferred by the belt conveyor 7. At the position A of the transfer by the belt conveyor 7, foot portions 20 of the comb terminal 8 are inserted into connection apertures 21 formed in the ceramic board 6. Accordingly, the ceramic board 6 in the state that the foot portions 20 of the comb terminals 8 are inserted into the connection apertures 21 thereof is drawn by the comb terminals 8 which are driven by the driving rollers 9 through the pins 10, and accordingly moved upon the rotation of the rollers 11 to a next step. Then, at the position B, the foot portions 20 of the comb terminals 8 are bent when the foot portions pass through the interval between a pair of the caulking rollers 12, so that the comb terminals 8 are temporarily secured to the ceramic board 6. Thereafter also, the ceramic board 6 is still drawn by the comb terminals 8 to be continuously transferred and processed together with the comb terminals 8. As shown in Fig. 2, the ceramic board 6, after finishing the first and second steps, is printed by the creamy solder 13 in the third step. In the fourth step, the chip part 14 is placed on the creamy solder 13. Then, in the fifth step, the chip part 14 is passed through the re-flow furnace (not shown), so that the comb terminals 8 and the chip part 14 are simultaneously soldered. A protective agent is coated and hardened in the eighth step in order to protect main functional parts which are dies-bonded and wire-bonded in the sixth and seventh steps, respectively. Then, in the ninth step, the ceramic board 6 and the comb terminal 8 are finally cut off per one unit. Stamping is conducted in the tenth step to achieve a completed product.

As has been described hereinabove, according to the manufacturing method of the present invention, since the ceramic board and the comb terminal are integrally connected to be driven simultaneously by the same driving of the rollers, thereby to realize continuous transfer and processing of the ceramic board and the comb terminals, the number of the driving means or mounting tools can be reduced. Furthermore, since it is so arranged according to the present invention that the chip part and the comb terminals are soldered to the ceramic board simultaneously, they can pass through the re-flow furnace in a reduced number of times, resulting in decrease of possibilities of generation of distortion in the ceramic board.

It is to be noted here that although the HiC board is made of ceramic in the present embodiment, the material of the HiC board is not restricted to ceramic. Also, although the comb terminals are temporarily secured to the HiC board through insertion of the foot portions of the comb terminal into the connection apertures of the HiC board according to the present invention, it is needless to say that the direction of the insertion is not restricted, and that the comb terminals may be temporarily secured to the HiC board through pressure-welding.

As is clear from the foregoing description of the present invention, the comb terminal provided by connecting a plurality of terminals is parallel along a line to form a shape of comb in long length is connected to the ceramic board so as to realize continuous transfer and continuous processing of the comb terminal and the ceramic board at the same time. Accordingly, it is not necessary to install transferring means and mounting tools separately for the comb terminals and the ceramic board. Moreover, the comb terminals and the chip part are soldered to the ceramic board simultaneously, and therefore only one re-flow furnace is enough in the present invention, thereby realizing a compact and inexpensive manufacturing apparatus. Further, since the comb terminals and the ceramic board pass through the re-flow furnace for less times, the ceramic board can be prevented from being deformed by heating and cooling operations, resulting in enhancement of the product accuracy and improvement of the yield.

## Claims

1. A method for manufacturing electronic parts, which comprises the steps of:
transferring a pair of elongated comb terminals (8) in a longitudinal direction parallel to each other;
mechanically securing a board (6) to said elongated comb terminals so as to transfer the board through said elongated comb terminals;
mounting chip parts (14) and soldering chip parts and said elongated comb terminals onto said board during the transfer; and
cutting said comb terminals to obtain separate electronic parts.

2. The method of claim 1,
wherein each of said chip parts mounted on said board is mechanically connected to a wiring pattern on said board simultaneously when said elongated comb terminals are mechanically connected to the wiring pattern of said board, in the soldering step.

## Patentansprüche

1. Verfahren zur Herstellung elektronischer Baugruppen,
gekennzeichnet durch folgende Verfahrensschritte:
Förderung eines Paares von verlängerten Kammanschlüssen (8) parallel zueinander in einer Längsrichtung;
mechanische Befestigung einer Platine (6) an den verlängerten Kammanschlüssen, um die Platine damit zu fördern, Befestigung und Einlöten von Chipteilen (14) sowie der verlängerten Kammanschlüsse auf der Platine während der Förderung, und
Abschneiden der Kammanschlüsse in der Weise, daß getrennte elektronische Baugruppen erhalten werden.

2. Verfahren nach Anspruch 1,
dadurch gekennzeichnet, daß jedes auf der Platine befestigte Chipteil gleichzeitig mechanisch mit einem Verdrahtungsmuster auf der Platine verbunden wird, wenn die verlängerten Kammanschlüsse während des Lötvorganges mechanisch mit dem Verdrahtungsmuster auf der Platine verbunden werden.

## Revendications

1. Procédé de fabrication de parties électroniques, qui comprend les opérations suivantes :
transférer une paire de bornes en forme de peigne allongées (8) dans une direction longitudinale parallèlement l'une à l'autre ;
fixer mécaniquement une plaquette (6) sur lesdites bornes en forme de peigne allongées de façon à transférer la plaquette par l'intermédiaire desdites bornes en forme de peigne allongées ;
monter des parties puces (14) et souder les parties puces et lesdites bornes en forme de peigne allongées sur ladite plaquette pendant le transfert ; et
couper lesdites bornes en forme de peigne de façon à obtenir des parties électroniques distinctes.

2. Procédé selon la revendication 1, où chacune desdites parties puces montées sur ladite plaquette est mécaniquement connectée à un motif de câblage se trouvant sur ladite plaquette en même temps que lesdites bornes en forme de peigne allongées sont mécaniquement connectées au motif de câblage de ladite plaquette, lors de l'opération de soudage.
